# EUROPÄISCHE PATENTSCHRIFT

(11) **EP 2 443 645 B1**
(45) Veröffentlichungstag und Bekanntmachung des Hinweises auf die Patenterteilung: **07.08.2019**
(21) Anmeldenummer: 10735220.5
(22) Anmeldetag: 15.06.2010
(51) Int. Cl.: H01J 37/244, H01J 37/256, H01J 37/28, G01N 23/00, G01T 1/00, H01L 31/02, H01L 31/0203

(54) **STÖRUNGSARMER SENSORKOPF FÜR EINEN STRAHLUNGSDETEKTOR SOWIE DIESEN STÖRUNGSARMEN SENSORKOPF ENTHALTENDER STRAHLUNGSDETEKTOR**
LOW-INTERFERENCE SENSOR HEAD FOR A RADIATION DETECTOR, AS WELL AS A RADIATION DETECTOR WHICH CONTAINS THIS LOW-INTERFERENCE SENSOR HEAD
TÊTE DE CAPTEUR PEU SENSIBLE AUX PANNES DESTINÉE À UN DÉTECTEUR DE RAYONNEMENT AINSI QUE DÉTECTEUR DE RAYONNEMENT ÉQUIPÉ DE LADITE TÊTE DE CAPTEUR PEU SENSIBLE AUX PANNES

(30) Priorität: 15.06.2009 DE 102009026946
(43) Veröffentlichungstag der Anmeldung: 25.04.2012
(73) Patentinhaber: Bruker Nano GmbH, 12489 Berlin (DE)
(72) Erfinder: FALKE, Meiken, 12489 Berlin (DE); KRÖMER, Robert, 12105 Berlin (DE)
(74) Vertreter: Gulde & Partner
(86) Internationale Anmeldenummer: PCT/EP2010/058361
(87) Internationale Veröffentlichungsnummer: WO 2010/146044

(56) Entgegenhaltungen:
- WO-A1-98/14979
- WO-A2-2009/016407
- DE-B3-102008 028 487
- US-A- 5 877 498
- US-A1- 2011 204 229
- LOWE B G ED - EDS : DAVID B WILLIAMS ET AL: "CHAPTER 2: Problems and Trends in X-Ray Detector Design for Microanalysis" 1. Januar 1995 (1995-01-01), X-RAY SPECTROMETRY IN ELECTRON BEAM INSTRUMENTS, PLENUM PRESS, PAGE(S) 7 - 19 , XP009136042 ISBN: 978-0-306-44858-4 Seiten 7-9
- Pnsensors Gmbh: "PNSensor - Research and Development of Advanced Radiation Sensors", , 9 February 2007 (2007-02-09), XP55043766, Retrieved from the Internet: URL:http://web.archive.org/web/20070209125 813/http://www.pnsensor.de/Welcome/index.h tml [retrieved on 2012-11-09]
- MCNALLY D ET AL: "Review of solid state photomultiplier developments by CPTA and photonique SA", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, vol. 610, no. 1, 21 October 2009 (2009-10-21), pages 150-153, XP026736828, ISSN: 0168-9002, DOI: 10.1016/J.NIMA.2009.05.140 [retrieved on 2009-05-30]
- DAVID MCNALLY: "Presentation for LIGHT 07", ?, 1 September 2007 (2007-09-01), XP55179523, Tegernsee
- David Mcnally: "Presentation for LIGHT 07", , 1 September 2007 (2007-09-01), XP55179534, Schloss Ringberg - Tegernsee Retrieved from the Internet: URL:https://indico.mpp.mpg.de/getFile.py/a ccess?contribId=43&sessionId=7&resId=0&mat erialId=slides&confId=65 [retrieved on 2015-03-26]
- D C Bell ET AL: "Energy dispersive X-ray analysis in the electron microscope" In: "Energy dispersive X-ray analysis in the electron microscope", 1 January 2003 (2003-01-01), XP55179528,
- "PCB package for 9.0 mm2 SSPMs", , 27 November 2007 (2007-11-27), XP55179526, Retrieved from the Internet: URL:[provided by Third Party under Art. 115 EPC] [retrieved on 2015-03-26]
- "Is stainless steel non-magnetic?", , 23 January 2009 (2009-01-23), XP55179544, Retrieved from the Internet: URL:https://web.archive.org/web/20090 1231521 33/http://bssa.org.uk!faq.pl,p?id=24 [retrieved on 2015-03-26]
- 1 January 2007 (2007-01-01), Conrad Elektronik, XP55179546,
- "Kupfer-Zink- Legierungen (Messing und Sondermessing)", , 1 March 2007 (2007-03-01), XP55179371, Retrieved from the Internet: URL:http://www.metall-breuckmann.de/downlo ad/Informationen_zu_Kupfer und_Zinklegierungen.pdf [retrieved on 2015-03-25]
- H Soltau ET AL: "SDDs - Silicon Detectors for EDS with a Performance at the Theoretical Limit", Microscopy and Microanalysis, vol. 14, no. S2, 1 August 2008 (2008-08-01), pages 1156-1157, XP55462364, ISSN: 1431-9276, DOI: 10.1017/S143192760808478X
- A Niculae ET AL: "Analyzing and Expanding the Detector Efficiency of Silicon Drift Detectors", Microscopy and Microanalysis, vol. 14, no. S2, 1 August 2008 (2008-08-01), pages 1170-1171, XP55462356, ISSN: 1431-9276, DOI: 10.1017/S1431927608088090
- Anonymous: "TopLine -TO", , 3 September 2004 (2004-09-03), XP55462519, Retrieved from the Internet: URL:https://web.archive.org/web/2004090323 3610/www.topline.tv/to.html [retrieved on 2018-03-23]

## Beschreibung

Die Erfindung betrifft einen störungsarmen Sensorkopf für einen Röntgendetektor sowie einen den störungsarmen Sensorkopf enthaltenden Strahlungsdetektor. Bei dem erfindungsgemäßen Strahlungsdetektor handelt es sich um einen Röntgendetektor.

Die Erfindung betrifft ferner die Verwendung des störungsarmen Sensorkopfes oder des Röntgendetektors für die (energiedispersive) Röntgenanalyse in der Mikroskopie unter Verwendung von Optiken für geladene Teilchen.

Historisch gewachsen ist die Analytik im Elektronenmikroskop unter anderem als so genannte Elektronenestrahlmikroanalyse, eine weit verbreitete Methode der Elementanalytik. Dabei wird Röntgenstrahlung, die in einem Elektronenmikroskop, beispielsweise in einem Rasterelektronenmikroskop (REM), Transmissionselektronenmikroskop (TEM) oder Raster/(Scanning)transmissionselektronenmikroskop (STEM), bei der Abtastung einer Probe durch einen Elektronenstrahl entsteht, detektiert und ausgewertet. Zunächst nur als Spezialanwendung in Zusammenhang mit hierfür besonders ausgelegten Geräten wie z.B. Elektronenstrahl-Mikrosonden geplant, hat sich die Röntgenanalytik allgemein zu einer in praktisch jedem REM/TEM-Labor routinemäßig angewendeten Methode entwickelt. Dabei werden verschiedene spezielle Analysetechniken, wie zum Beispiel wellenlängendispersive (WDX) und energiedispersive Röntgenanalytik (EDX (auch WDS und EDS genannt)) verwendet. Der entscheidende Schritt hierfür war die Einführung von energiedispersiven Röntgendetektoren (EDX-Detektoren), die sich durch ihre einfache und robuste Bauweise, Wartungsarmut, stabile Arbeitsweise und nicht zuletzt dem relativ großen erfassten Raumwinkel (engl. solid angle) auszeichnen.

EDX-Detektoren verfügen über ein Eingangsfenster, einen Halbleiterkristall, der axial in Sichtachse des Detektors auf einem sogenannten Kühlfinger angeordnet ist, und eine Verstärkereinheit, die typischerweise einen Feldeffekt-Transistor (FET) und einen Vorverstärker aufweist. Ein EDX-Detektor weist ein relativ großes, homogenes Volumen auf, das Röntgenstrahlung aus nahezu beliebiger Richtung erfassen kann. Insbesondere der große Raumwinkel der von EDX-Detektoren erfassten Röntgenstrahlung, d.h. der große Anteil der genutzten Strahlung an der insgesamt erzeugten, gestattet es, eine Mikroanalyse an gebräuchlichen, abbildenden Elektronenmikroskopen durchzuführen.

Die Entwicklung der REMs und TEMs hin zu immer besserer elektronenoptischer Auflösung, die Verwendung bestimmter Elektronenquellen und energiedispersiver Elektronenfilter, die Verbesserung der Elektronendetektoren, aber auch das vermehrte Interesse an organischen oder anderweitig empfindlichen Proben, haben den üblichen Strahlstrom soweit sinken lassen, dass in vielen Fällen auch mit EDX-Detektoren deutliche Grenzen gesetzt sind. Dies ist besonders im Bereich der Nanoanalytik von Bedeutung, das heißt wenn Probenbereiche kleiner 1 Mikrometer vollständig und quantitativ auf ihre Element- und Phasenzusammensetzung bzw. Verunreinigungen analysiert werden sollen. Außerdem stellen kleine (im Nanometerbereich) oder kleinere dünne Probenbereiche ein geringeres Anregungsvolumen für Wechselwirkungsstrahlung, insbesondere Röntgenstrahlung dar und liefern daher weniger Strahlung für den Detektor. Um die erfasste Strahlungsmenge zu erhöhen werden routinemäßig die Messzeiten verlängert. Nachteilig daran ist vor allem, dass lange Messzeiten beispielsweise durch Probendrift sehr störungsanfällig sind.

Alternativ können großflächigere Detektoren eingesetzt werden, die allerdings schwer handhabbar sind, eine schlechtere Auflösung und ein schlechteres Röntgendetektionsverhalten aufweisen und zudem stärker gekühlt werden müssen.

Besonders deutlich werden diese Probleme bei sogenannten SDD-Detektoren (Siliziumdriftdetektoren, silicon drift detector), die von ihrer physikalischen Wirkungsweise und Bauart her ein Vielfaches der üblichen Strahlungsmenge erfassen könnten. Bei proben- oder gerätebedingter Begrenzung der zur Verfügung stehenden Strahlungsmenge besteht der einzige Weg, die erfasste Strahlungsmenge zu vergrößern und damit die Messzeit zu verringern, darin, den vom Detektor erfassten Raumwinkel der Strahlung zu erhöhen. Zu diesem Zweck ist ein möglichst geringer Abstand eines oder mehrerer kleiner Detektoren zu der Probe wünschenswert.

Der Detektor-Proben-Abstand ist jedoch durch die Detektorgröße und die baulichen Gegebenheiten des Elektronenmikroskops limitiert. Der zur Bilderzeugung optimale Arbeitsabstand zwischen Polschuh und Probe liegt im REM bei ca. 4 mm, wobei eine Vergrößerung dieses Arbeitsabstandes die Bildqualität deutlich verschlechtert. Bei der Anwendung der EDX in TEM und STEM Systemen sind die verfügbaren Detektorgrößen zusätzlich durch die speziellen Designgegebenheiten im TEM limitiert, da sich die Probe im Polschuh der Elektronenlinsen befindet.

Um den EDX-Detektor möglichst nah an der Probe, d.h. optimalerweise zwischen Polschuh und Probe im Elektronenmikroskop zu positionieren, müssen die Detektoren verkleinert werden. Ein entsprechend miniaturisierter Detektor ist beispielsweise in der DE 10 2008 014 578.5 beschrieben.

US 5,877,498 A beschreibt verschiedene Geometrien und Anordnungsmöglichkeiten von Röntgendetektoren für die Mikroanalyse. Ferner wird die Problematik einer nahen Anordnung des Röntgendetektors an den anregenden Elektronenstrahl diskutiert. Um diesen nicht zu beeinflussen, wird die Notwendigkeit beschrieben, Komponenten des Röntgendetektors aus nichtmagnetischen Materialien, wie Aluminium, Kupfer oder entmagnetisiertem Edelstahl herzustellen. Dies gelte insbesondere für Komponenten des Detektors, die dem Elektronenstrahl zugewandt sind, sowie für die Materialien des Gehäuses.

WO 98/14979 A beschreibt einen annularen Röntgendetektor für die Mikroanalyse. Um das statische magnetische Feld des magnetischen Linsensystems nicht zu stören, wird beschrieben, die Detektor- und Montagematerialien aus einem nichtmagnetischen Material mit einer Permeabilität nahe dem Vakuum herzustellen.

B. G. Lowe ("Problems and Trends in X-Ray Detector Design for Microanalysis" in "X-Ray Spectrometry in Electron Beam Instruments, Ed. D. Williams et al., Plenum Press, New York, 1995, S. 7-19) befasst sich mit Problemen energiedispersiver Röntgendetektoren in Elektronenmikroskopen. Insbesondere wird die Problematik des Erfordernisses eines nahen Abstands zwischen dem Sensor und dem Elektronenstrahl diskutiert. Es wird ferner festgestellt, dass magnetische Materialien zu einer Bildverzerrung und -verschiebung führen, wenn sie in großer Nähe zum Elektronenstrahl angeordnet sind. In verschiedenen Anordnungen von Röntgendetektoren in Elektronenmikroskopen werden als Materialien für verschiedene Bauteile Edelstahl, Wolfram, Tantal und Aluminiumlegierungen genannt.

Die Erfinder haben beobachtet, dass durch die räumliche Nähe des Detektors allerdings die Felder zur Elektronenstrahlfokussierung bzw. -ablenkung gestört werden. Dies stellt insbesondere bei TEM/STEM Systemen ein großes Problem dar, wo sich die Probe im Polschuh der Elektronenlinse befindet. Wird der erzeugte Feldverlauf der Elektronenlinse durch den Detektor gestört, wird die Abbildungsqualität deutlich verschlechtert oder eine Abbildung ist gar nicht mehr möglich. Zusätzlich kommt hinzu, dass inzwischen Elektronenmikroskope mit korrigierter sphärischer und in Zukunft auch chromatischer Aberration auf den Markt gelangen. Für diese Geräte ist die Störung des Linsenfeldes der Optik besonders schädlich, da so auch die Funktion der Aberrationskorrektoren gestört oder vollständig außer Kraft gesetzt wird.

Es ist daher die Aufgabe der vorliegenden Erfindung, die Probleme im Stand der Technik zu überwinden und einen störungsarmen Detektor für EDX bereitzustellen. Dabei soll der Detektor bis auf weniger Millimeter an die Optik in Elektronenmikroskopen näherbar sein, ohne dass die Abbildungsqualität der Mikroskope leidet und Abberationskorrektoren gestört oder unbrauchbar werden.

Die Aufgabe wird nach einem ersten Aspekt der Erfindung durch einen störungsarmen Sensorkopf mit den Merkmalen des Anspruchs 1 gelöst. Weitere erfindungsgemäße Ausgestaltungen sind mit den Merkmalen der Unteransprüche beschrieben.

Die Erfindung betrifft einen störungsarmen Sensorkopf für einen Röntgendetektor, umfassend als Bauteile mindestens eine Leiterplatte mit einer Stirnfläche; einen auf der Stirnfläche der Leiterplatte angeordneten für Röntgenstrahlung empfindlichen Sensorchip; eine Mehrzahl von Signal- und Steueranschlüssen, enthaltend Kontaktstifte zum Betrieb des Sensorchips, wobei die Kontaktstifte zur elektrischen Isolation jeweils von einem Glaskörper umschlossen sind, der an beiden Enden offen ist und somit den Kontaktstift zur Kontaktierung freigibt; und ein auf einer von der Stirnfläche abgewandten Seite der Leiterplatte angeordnetes Mittel zur Kühlung und/oder Wärmeableitung. Erfindungsgemäß besteht die Mehrzahl der Kontaktstifte aus einem Material oder mehreren Materialien, dessen bzw. deren Permeabilitätszahl (µᵣ) kleiner als 1,5 ist, wobei das Material beziehungsweise die Materialien ausgewählt ist bzw. sind aus geglühten Nickel-Legierungen und geglühtem austenitischen Edelstahl mit der Werkstoffnummer 1.4429, 1.4406, 1.4404, 1.4301, 1.3964, 1.3960 und 1.3952.

Überraschenderweise wurde gefunden, dass ein herkömmlicher Sensorkopf eine deutliche Störung der Elektronenoptik verursacht. Erfindungsgemäß wird der Sensorkopf daher derart konstruiert, dass er nur möglichst kleine Störungen der Optik für geladene Teilchen aufweist. Überraschend ist dabei, dass die Kontaktstifte der Signal- und Steueranschlüsse den größten Beitrag zur durch den Sensorkopf verursachten Störung liefern. In der Erfindung handelt es sich bei den Kontaktstiften also um elektrisch leitende Materialien in Stiftform, die vorzugsweise vergoldet werden.

In einer bevorzugten Ausführungsform der Erfindung handelt es sich bei den Kontaktstiften um Vollzylinder mit einem Durchmesser im Bereich von 0,1 bis 1,5 mm, vorzugsweise 0,4 bis 0,8 mm. Eine bevorzugte Länge der Kontaktstifte liegt im Bereich von 0,1 bis 3 cm, vorzugsweise im Bereich von 0,5 bis 2 cm, noch bevorzugter im Bereich von 1 bis 1,5 cm. Die Ausgestaltung als Zylinder ist fertigungstechnisch von Vorteil, erfindungsgemäß sind allerdings auch viereckige oder vieleckige Stäbe in den angegebenen Größenbereichen mit umfasst. Die runden oder vieleckigen Kontaktstifte können im Wesentlichen gerade oder gebogen sein. Gebogene Kontaktstifte werden bevorzugt eingesetzt, wenn die Detektorgeometrie dies erfordert.

Zur Minimierung des Einflusses auf die Optik für geladene Teilchen wird erfindungsgemäß die Mehrzahl der Kontaktstifte, aus einem Material oder mehreren Materialien hergestellt, deren Permeabilitätszahl (µᵣ), auch relative Permeabilität oder magnetische Permeabilitätszahl genannt, kleiner als 1,5 ist. In einer bevorzugten Ausgestaltung der Erfindung werden 2/3 der Kontaktstifte und noch bevorzugter alle Kontaktstifte aus einem Material, dessen Permeabilitätszahl (µᵣ) kleiner als 1,5 ist, hergestellt.

In einer besonders bevorzugten Ausgestaltung der Erfindung werden die Kontaktstifte aus einem Material oder mehreren Materialien hergestellt, deren Permeabilitätszahl (µᵣ) kleiner als 1,35, vorzugsweise kleiner als 1,2, noch bevorzugter kleiner als 1,1, weiter bevorzugt kleiner als 1,05 und noch bevorzugter kleiner als 1,01 ist. Des Weiteren müssen die Materialeigenschaften, insbesondere die magnetische Permeabilität der erfindungsgemäß verwendeten Materialien nach mechanischer Bearbeitung reversibel sein, insbesondere darf durch die Bearbeitung keine permanente Erhöhung der Permeabilität verursacht werden. Weiterhin müssen die thermischen Ausdehnungskoeffizienten der erfindungsgemäß verwendeten Materialien auf einander abgestimmt sein. Geglühte Nickel-Legierungen und die genannten geglühten austenitischen Edelstähle erfüllen diese Bedingungen.

Als Basismaterial für die Leiterplatte kommen alle im Stand der Technik bekannten Materialien in Frage. Beispielsweise kann mit Phenolharz oder Epoxidharz getränktes Papier, mit Epoxidharz getränktes Glasfasergewebe, Teflon, Polyesterfolie oder Keramik verwendet werden. Die Leiterbahnen bestehen aus den dem Fachmann bekannten leitenden Materialien, vorzugsweise Kupfer. In einer besonders bevorzugten Ausführungsform der Erfindung ist die Leiterplatte eine Multilayer Verbundkeramik. Die Herstellung von entsprechenden Verbundkeramiken ist dem Fachmann bekannt.

Als Sensorchip kommen alle dem Fachmann bekannten für Teilchenstrahlung empfindlichen Sensorchips in Frage, die für Röntgenstrahlung empfindlich sind. Geeignete Sensorchips sind beispielsweise ein Si(Li)-Detektor, ein High-Purity-Germanium-Detektor (HPGe-Detektor), eine Positive-Intrinsic-Negative-Diode (PIN-Diode), ein aus Verbindungshalbleitern bestehender Detektor, ein Silizium-Driftdetektor (SDD) mit externen Transistoren oder ein Silizium-Driftdetektor mit integriertem FET (I-FET SDD). Vorzugsweise handelt es sich bei dem erfindungsgemäß verwendeten Sensorchip um einen Silizium-Driftdetektor (SDD).

Zur Stabilisierung der thermischen Verhältnisse und gegebenenfalls zur Erzeugung von Arbeitstemperaturen, die unterhalb der Raumtemperatur liegen, weist der Sensorkopf auf der Rückseite der Leiterplatte ein Mittel zur Kühlung und/oder Wärmeableitung auf. Geeignete Mittel zur Kühlung und/oder Wärmeableitung sind dem Fachmann bekannt. Vorzugsweise umfasst das Mittel zur Kühlung und/oder Wärmeableitung ein thermoelektrisches Kühlelement.

In einer weiteren Ausgestaltung der Erfindung weist der erfindungsgemäße Sensorkopf ferner eine Bodenplatte zur Einfassung der Kontaktstifte auf, wobei die Bodenplatte aus einem Material oder mehreren Materialien besteht, deren Permeabilitätszahl (µᵣ) kleiner als 1,5 ist. Vorzugsweise weist die Bodenplatte Bohrungen auf, welche die erfindungsgemäßen Kontaktstifte aufnehmen und mechanisch fixieren. In einer bevorzugten Ausführungsform ist die Bodenplatte als Ring ausgestaltet. Durch die zentrale Öffnung der Bodenplatte wird das Mittel zur Kühlung und/oder Wärmeableitung geführt oder die zentrale Öffnung der Bodenplatte wird durch das Mittel zur Kühlung und/oder Wärmeableitung ausgefüllt. Geeignete Materialien für die erfindungsgemäße Bodenplatte müssen neben einer Permeabilitätszahl (µᵣ) kleiner als 1,5 auch eine ausreichende mechanische Stabilität aufweisen, so dass die Bodenplatte nicht beim Betrieb des Detektors verbogen wird und die Kontaktstifte zuverlässig in ihrer Position gehalten werden. Dabei liegt die Dicke der Bodenplatte im Bereich von 0,1 bis 5 mm, vorzugsweise im Bereich von 0,5 bis 3 mm, noch bevorzugter im Bereich von 1,5 bis 2,5 mm. Zudem muss das Material derart gewählt werden, dass das Einfügen von Bohrungen möglich ist und durch die mechanische Bearbeitung möglichst keine Veränderung der magnetischen Permeabilität der Bodenplatte induziert wird.

Besonders bevorzugt weist das Material der Bodenplatte eine Permeabilitätszahl (µᵣ) kleiner als 1,35, vorzugsweise kleiner als 1,2, noch bevorzugter kleiner als 1,1, weiter bevorzugt kleiner als 1,05 und noch bevorzugter kleiner als 1,01 auf. Geeignete Materialien zur Herstellung der erfindungsgemäßen Bodenplatte umfassen austenitischen Edelstahl, geglühte Nickel-Legierungen, Tantal, Zirkonium, Wolfram, Platin, Palladium, Titan oder Mischungen daraus. In einer bevorzugten Ausgestaltung besteht die erfindungsgemäße Bodenplatte aus geglühtem austenitischen Edelstahl, und besonders bevorzugt aus geglühtem Edelstahl mit der Werkstoffnummer 1.4429, 1.4406, 1.4404, 1.4301, 1.3964, 1.3960 oder 1.3952, insbesondere mit der Werkstoffnummer 1.4301.

In einer weiteren bevorzugten Ausgestaltung der Erfindung ist der Sensorkopf von einem Gehäuse umschlossen, wobei das Gehäuse im Bereich des Sensorchips ein Eingangsfenster aufweist und das Gehäuse aus einem Material oder mehreren Materialien besteht, deren Permeabilitätszahl (µᵣ) kleiner als 1,5 ist. Dabei ist das Eingangsfenster für die vom Sensorchip detektierte Strahlung permeable. Das Gehäuse bietet den empfindlichen Bauteilen des Sensorkopfes Schutz vor mechanischen Stößen und dient gleichzeitig als Grifffläche.

In einer weiteren bevorzugten Ausgestaltung der Erfindung ist der Sensorkopf in den Seitenbereichen von einem Gehäuse umschlossen, wobei das Gehäuse mit dem Sensorchip bündig abschließt.

In beiden alternativen Ausgestaltungen, d.h. mit und ohne Eingangsfenster kann das Gehäuse in einer Ausführung vakuumdicht oder in einer anderen Ausführung offen gestaltet sein.

Vorzugsweise weisen die Materialien für ein erfindungsgemäßes Gehäuse eine Permeabilitätszahl (µᵣ) kleiner als 1,35, insbesondere kleiner als 1,2, bevorzugter kleiner als 1,1, weiter bevorzugt kleiner als 1,05 und noch bevorzugter kleiner als 1,01 auf. Geeignete Materialien für ein erfindungsgemäßes Gehäuse umfassen einen austenitischen Edelstahl, geglühte Nickel-Legierungen, Tantal, Zirkonium, Wolfram, Platin, Palladium, Titan oder Mischungen daraus. In einer bevorzugten Ausgestaltung besteht das erfindungsgemäße Gehäuse aus geglühtem austenitischen Edelstahl weiter bevorzugt aus geglühtem Edelstahl mit der Werkstoffnummer 1.4429, 1.4406, 1.4404, 1.4301, 1.3964, 1.3960 oder 1.3952, noch bevorzugter aus geglühtem Edelstahl mit der Werkstoffnummer 1.4301.

In einer weiteren Ausgestaltung der Erfindung sind die Haftschichten und/oder Sperrschichten zwischen den Bauteilen dünner als 3 µm, vorzugsweise dünner als 2 µm, weiter bevorzugt dünner als 1,5 µm. Haftschichten werden beispielsweise auf den Kontaktstiften verwendet, um die Vergoldung stabil auftragen zu können. Sperrschichten dienen dazu, die Diffusion zwischen den einzelnen Bauteilen zu verhindern.

In einer weiteren bevorzugten Ausgestaltung bestehen die Haftschichten und/oder Sperrschichten aus einem Material oder mehreren Materialien, deren Permeabilitätszahl (µᵣ) kleiner als 1,5, vorzugsweise kleiner als 1,35, bevorzugter kleiner als 1,2, noch bevorzugter kleiner als 1,1, weiter bevorzugt kleiner als 1,05 und noch weiter bevorzugt kleiner als 1,01 ist.

Die Verbindung der einzelnen Bauteile untereinander erfolgt in einer weiteren Ausgestaltung lotfrei oder ist mit einem Lot erstellt, dessen Permeabilitätszahl (µᵣ) kleiner als 1,5, vorzugsweise kleiner als 1,35, bevorzugter kleiner als 1,2, noch bevorzugter kleiner als 1,1, weiter bevorzugt kleiner als 1,05 und noch weiter bevorzugter kleiner als 1,01 ist. Weitere geeignete Lötmaterialien für den erfindungsgemäßen Sensorkopf enthalten weniger als 50% Nickel, vorzugsweise weniger als 20% Nickel, noch bevorzugter weniger als 10% Nickel, weiter bevorzugt weniger als 5% Nickel und am meisten bevorzugt 0% Nickel. Vorteilhafterweise werden erfindungsgemäß Lote eingesetzt, die eine Schmelztemperatur von Tₘ ≥ 600°C, vorzugsweise Tₘ ≥ 900°C aufweisen. Dabei ist zu beachten, dass die thermischen Ausdehnungskoeffizienten der verwendeten Materialien aufeinander abgestimmt sein müssen. Geeignete Lote umfassen Silber, Gold, Kupfer, Palladium oder eine Mischung daraus. Vorzugsweise besteht das Lot aus einer Mischung aus Silber und Kupfer. Erfindungsgemäß sind auch Silber-Kupfer-Mischungen umfasst, die Spuren von anderen Metallen enthalten. Erfindungsgemäß sind die Kontaktstifte zur Isolation und Vermeidung ungewollter elektrischer Leitung von einem röhrenförmigen Glaskörper umschlossen, der an beiden Enden offen ist und somit den Kontaktstift zur Kontaktierung freigibt. Dabei wird das Glas der Einglasung derart gewählt, dass die Schmelztemperatur des Glases größer oder gleichgroß wie die Glühtemperatur des Edelstahls ist. Vorteilhafterweise wird dadurch während des Einglasens gleichzeitig der Edelstahl geglüht. Dies ist besonders vorteilhaft, wenn durch die Bearbeitung und das Formen der Kontaktstifte eine Veränderung der magnetischen Permeabilität im Edelstahl hervorgerufen wurde. Dabei ist zu beachten, dass die thermischen Ausdehnungskoeffizienten der verwendeten Materialien aufeinander abgestimmt sein müssen.

In einer weitern Ausführungsform finden Löt-, Glüh- und Einglasprozess in einem Prozessschritt statt.

In einer weiteren Ausführungsform der Erfindung umfasst das Mittel zur Kühlung und/oder Wärmeableitung ein thermoelektrisches Kühlelement und einen Sockel. Das thermoelektrische Kühlelement umfasst vorzugsweise mehrere Peltier-Elemente, die zwischen zwei Keramikplatten angeordnet sind. Die Keramikplatten stellen die Kalt- und die Warmseite des thermoelektrischen Kühlelements dar, wobei die Kaltseite die der Leiterplatte zugewandte Seite ist. In einer Ausführung ist die Kaltseite durch ein Kühlmittel, bzw. ein wärmeleitendes Material mit der Leiterplatte verbunden. In einer weiteren Ausführungsform ist die Kaltseite des thermoelektrischen Kühlelements gleichzeitig die Leiterplatte. Geeignete Materialien für das thermoelektrische Kühlelement sind Aluminium-Oxid-Keramiken, Aluminium-Nitrid-Keramiken, Bismut-Tellurid und Silizium-Germanium.

Der Sockel dient zur mechanischen Befestigung der Bauteile des Sensorkopfes und gleichzeitig als Mittel zur Wärmeableitung. Vorzugsweise besteht der Sockel aus einem Material mit einer guten Wärmeleitfähigkeit. Geeignete Materialien für einen erfindungsgemäßen Sockel sind Kupfer, Silber, Gold, oder Mischungen daraus. Vorzugsweise wird Kupfer zur Herstellung des Sockels verwendet. Ist die erfindungsgemäße Bodenplatte als Ring ausgestaltet, so füllt der Sockel die zentrale Öffnung der Bodenplatte aus.

Durch die erfindungsgemäße Auswahl und Kombination der Materialien ist es gelungen, einen Sensorkopf zur Verfügung zu stellen, der den herkömmlichen Anforderungen der EDX an Sensitivität, Stabilität und geometrischen Anforderungen entspricht und darüber hinaus störungsarm ist und die Optik für geladene Teilchen nur gering beeinflusst. Damit wird ein Sensorkopf bereit gestellt, der die Abbildungsqualität und Auflösung im REM oder TEM erhält und gleichzeitig die Chancen der Nanoanalytik mittels Strahlungsanalytik, insbesondere mittels EDX eröffnet.

Es ist ein weiterer Gegenstand der Erfindung, einen Strahlungsdetektor zur Verfügung zu stellen, der mit einem erfindungsgemäßen störungsarmen Sensorkopf ausgestattet ist. Erfindungsgemäß kann der erfindungsgemäße störungsarme Sensorkopf in jeglicher Art von Detektoren eingesetzt werden, die zur Detektion von Röntgenstrahlung verwendet werden können.

Dementsprechend handelt es sich bei dem erfindungsgemäßen Strahlungsdetektor um einen Röntgendetektor, insbesondere um einen EDX-Detektor, der einen erfindungsgemäßen störungsarmen Sensorkopf aufweist.

Die Erfindung betrifft ferner die Verwendung eines erfindungsgemäßen störungsarmen Sensorkopfes oder eines erfindungsgemäßen Strahlungsdetektors zur Detektion von Röntgenstrahlung in einem Mikroskop mit einer Optik für geladene Teilchen, insbesondere in einem Elektronen- oder lonenmikroskop. Vorzugsweise wird der störungsarme Sensorkopf oder der Detektor mit einem erfindungsgemäßen störungsarmen Sensorkopf in Rasterelektronenmikroskopen (REM), und allen Arten von Transmissionselektronenmikroskopen (TEM), insbesondere Raster/(Scanning)transmissionselektronenmikroskopen (STEM), in REMs mit TEM-Polschuh, in FIB-Geräten (focused ion beam) mit kombinierter Elektronen- und Ionenoptik und in Inonenmikroskopen eingesetzt.

Die Erfindung wird nachfolgend anhand von Ausführungsbeispielen und den dazugehörigen Zeichnungen näher erläutert. Es zeigen:
- Fig. 1: einen schematischen Aufbau zur EDX mit einem Strahlungsdetektor 74 am REM (Fig. 1A) und am TEM (Fig. 1B);
- Fig. 2: einen erfindungsgemäßen störungsarmen Sensorkopf 30 in der Seitenansicht;
- Fig. 3: einen erfindungsgemäßen störungsarmen Sensorkopf 30 in der Aufsicht;
- Fig. 4: die Bildqualität in einem TEM nach Einschwenken des Strahlungsdetektors mit einem erfindungsgemäßen störungsarmen Sensorkopf 30.

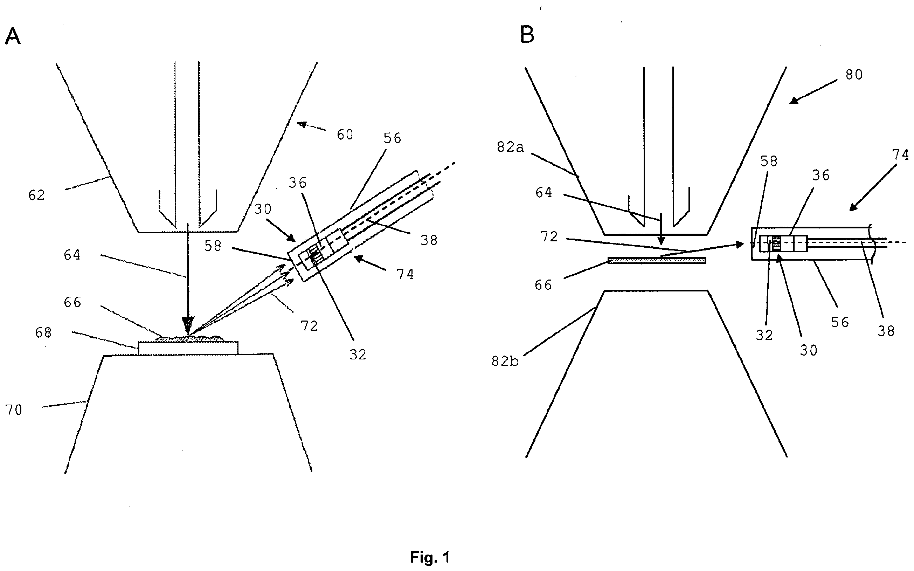

Fig. 1A zeigt schematisch einen experimentellen Aufbau zur EDX, bei der ein insgesamt mit 60 bezeichnetes REM einen Polschuh 62 aufweist, aus welchem ein Elektronenstrahl 64 austritt. Der Elektronenstrahl 64 ist auf eine Probe 66 gerichtet, die von einem Probenhalter 68 gehalten wird, welcher sich auf einem Probentisch 70 befindet. Der aus dem Polschuh 62 des Elektronenmikroskops 60 heraustretende Elektronenstrahl 64 regt die im Probenhalter 68 gehaltene Probe 66 an. Infolge dessen wird Strahlung 72 von der Probe 66 emittiert und nachfolgend in einem Strahlungsdetektor 74 detektiert. In der gezeigten Ausgestaltung handelt es sich um Röntgenstrahlung 72 und demnach auch um einen Röntgendetektor 74.

Der EDX-Detektor 74, von dem hier lediglich der so genannte Kühlfinger dargestellt ist, weist einen Sensorkopf 30 mit einem Halbleiterkristall als Sensorchip 32 auf. Eine röntgensensitive Stirnfläche des Sensorchips 32 wird von der eintretenden Röntgenstrahlung 72 bestrahlt. Rückseitig des Sensorkopfes 30 weist der Röntgendetektor 74 ein Mittel zur Kühlung und/oder Wärmeableitung 36 auf, das insbesondere ein thermoelektrisches Kühlelement umfasst. Der Sensorkopf 30 und das thermoelektrische Kühlelement sind von einem Gehäuse 56 umgeben. Im Bereich des Sensorchips 32 weist das Gehäuse 56 ein Eingangsfenster 58 auf, das optional und für die Röntgenstrahlung 72 permeable ist. Der Winkel zwischen Detektorachse 38 (gestrichelt) und Probennormalen kann durch Detektor- und Probenkippung verändert werden. Auch die Detektorhöhe ist variabel.

In Fig. 1B ist schematisch ein TEM 80 mit EDX gezeigt. Die Probe 66 ist hier im Polschuh, d.h. zwischen dem oberen Polschuhteil 82a und dem unteren Polschuhteil 82b angeordnet. Der Elektronenstrahl 64 tritt aus dem oberen Polschuhteil 82a aus und durchstrahlt die Probe 66. Infolge der Bestrahlung wird von der Probe 66 Röntgenstrahlung 72 emittiert, die nachfolgend in einem Röntgendetektor 74 detektiert wird. Der Röntgendetektor 74 entspricht dem in Fig. 1A gezeigten EDX-Röntgendetektor 74.

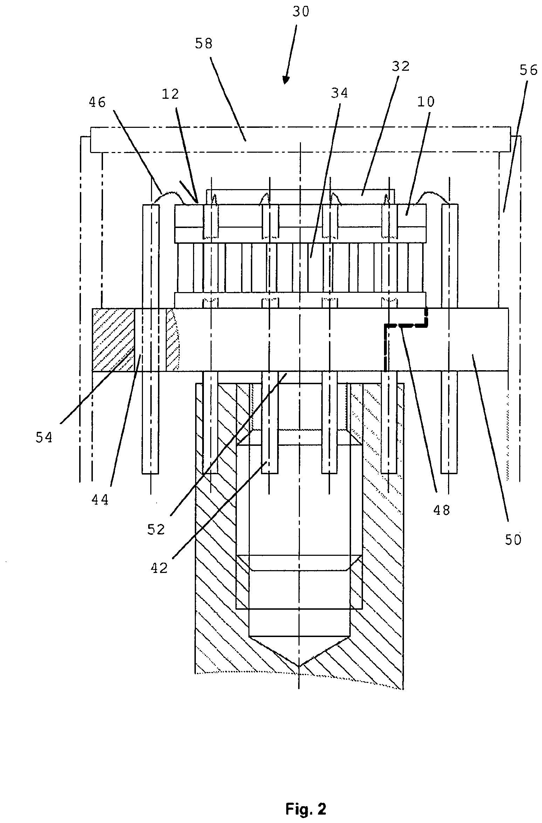

Fig. 2 zeigt einen erfindungsgemäßen Sensorkopf 30 für einen Röntgendetektor 74 schematisch in der Seitenansicht. Ein Sensorchip 32 ist mittig auf einer Stirnfläche 12 einer Leiterplatte 10 montiert. Bei dem Sensorchip 32 handelt es sich um einen Siliziumchip, die Leiterplatte 10 ist eine Multilayer-Verbundkeramik. Auf einer von der Stirnfläche 12 abgewandten Seite ist ein Kühlelement 34 angeordnet. Bei dem Kühlelement 34 handelt es sich um ein thermoelektrisches Kühlelement, insbesondere mit Bismut-Tellurid-Peltier-Elementen.

Der Sensorchip 32, die Leiterplatte 10 und das thermoelektrische Kühlelement 34 sind zur mechanischen Befestigung auf einem Sockel 52 aus Kupfer montiert, der das Zentrum einer ringförmigen Bodenplatte 50 aus geglühtem austenitischem Edelstahl 1.4301 bildet. Sockel 52 und Bodenplatte 50 sind zur Befestigung verlötet. Als Lot 48 wurde eine 1:1-Mischung aus Kupfer und Silber verwendet. Der Durchmesser der Bodenplatte 50 ist größer als die Diagonale der Stirnfläche 12 der Leiterplatte 10. In den Randbereichen der Bodenplatte 50 befinden sich Bohrungen 54, die derart in der Bodenplatte 50 angeordnet sind, dass sie nicht durch die Stirnfläche 12 der Leiterplatte 10 abgedeckt werden. Die Bohrungen 54 nehmen röhrenförmige Glaskörper 44 mit sich darin befindenden Kontaktstiften 42 auf. Die Kontaktstifte 42 stellen zum Betrieb des Sensorchips 32 benötigte Signal- und Steueranschlüsse dar und sind aus einer Wolfram-Titan-Legierung gefertigt. Auf der dem Sensorchip 32 zugewandten Seite schließen die Kontaktstifte 42 in der gewählten schematischen Darstellung mit der Stirnfläche 12 der Leiterplatte 10 bündig ab. Von den Enden der Kontaktstifte 42 führen Bonddrähte 46 in Form einer Schlaufe zu auf der Leiterplatte 10 montierten Bondinseln. Der Sensorkopf 30 ist von einem Gehäuse 56 aus austenitischem Edelstahl 1.4301 umgeben. Im Bereich der Sensorchips 32 weist das Gehäuse 56 ein Eingangsfenster 58 auf, das für Röntgenstrahlen 72 permeable ist.

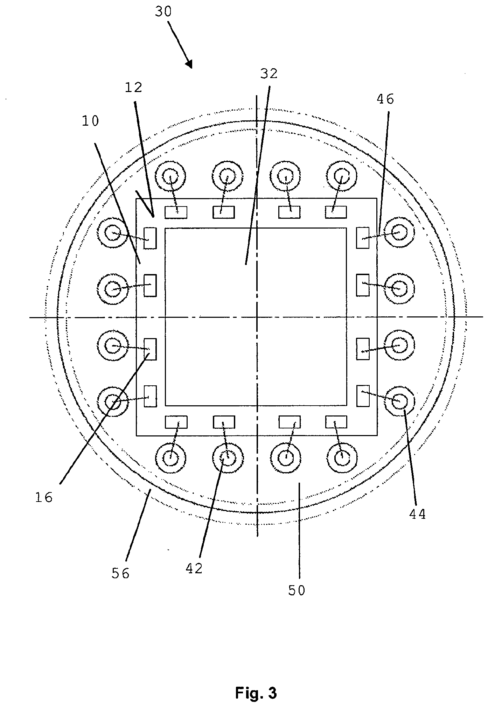

Die Fig. 3 zeigt den erfindungsgemäßen Sensorkopf 30 für den Röntgendetektor 74 schematisch in der Aufsicht. Die Beschreibung der Bauteile des Sensorkopfes 30 erfolgt von oben nach unten. Der Sensorchip 32 und die darunter liegende Leiterplatte 10 besitzen eine quadratische Grundfläche, wobei die Stirnfläche 12 der Leiterplatte 10 größer als die Fläche des Sensorchips 32 ist. Auf der Stirnfläche 12 der Leiterplatte 10 sind entlang der Seitenflächen des Sensorchips 32 Bondinseln 16 montiert, von denen Bonddrähte 46 zu den Kontaktstiften 42 führen. Die Kontaktstifte 42 sind mit den Glaskörpern 44 in den Bohrungen der Bodenplatte 50 angeordnet, wobei der Durchmesser der Bodenplatte 50 größer als die Diagonale der Stirnfläche 12 der Leiterplatte 10 ist, so dass die Kontaktstifte 42 außerhalb der Stirnfläche 12 der Leiterplatte 10 angeordnet werden. Der Sensorkopf 30 ist vom Gehäuse 56 umgeben. Der Durchmesser des Gehäuses 56 ist größer als der Durchmesser der Bodenplatte 50.

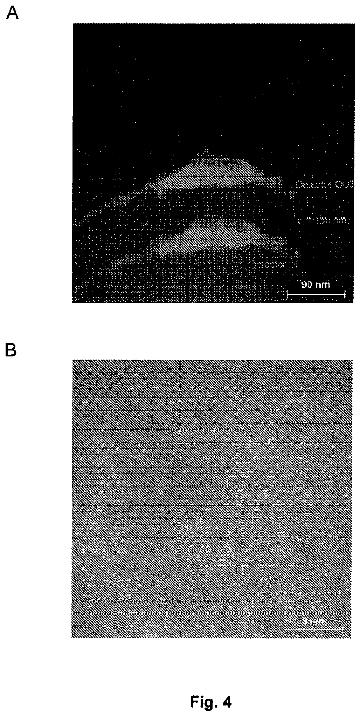

Fig. 4 zeigt zwei Beispielabbildungen aufgenommen mit einem Jeol 2200 FS bei 200KeV Beschleunigungsspannung. Der Detektor wurde in dem TEM Polschuh auf einen Abstand von 15,7 mm zur Probe genähert. Wird ein erfindungsgemäßer Detektor derart der Probe genähert, beträgt die Bildverschiebung noch 159 nm (Fig. 4A). Die Abbildungsqualität wird nicht weiter beeinträchtigt. Bei Verwendung eines herkömmlichen Detektors wäre das Bild nach Annäherung des Detektors außerhalb des Bildfeldes lokalisiert.

Fig. 4B zeigt die hochauflösende Gitterabbildung von Silizium in [110]-Zonenachse im high annular dark field Modus. Der Detektor ist wiederum auf 15,7 mm Abstand zur Probe genähert. Die Abbildungsfunktion der Elektronenlinse wird durch den Detektor nur noch minimal beeinträchtigt, die Gitterstruktur ist gut zu erkennen.

### Bezugszeichenliste

- 10: Leiterplatte
- 12: Stirnfläche
- 16: Bondinsel
- 30: Sensorkopf
- 32: Sensorchip
- 34: thermoelektrisches Kühlelement
- 36: Mittel zur Kühlung und/oder Wärmeableitung
- 38: Detektorachse
- 42: Kontaktstift
- 44: Glaskörper
- 46: Bonddraht
- 48: Lot
- 50: Bodenplatte
- 52: Sockel
- 54: Bohrung
- 56: Gehäuse
- 58: Eingangsfenster
- 60: REM
- 62: Polschuh
- 64: Elektronenstrahl
- 66: Probe
- 68: Probenhalter
- 70: Probentisch
- 72: (Röntgen-)Strahlung
- 74: (Röntgen-)Strahlungsdetektor
- 80: TEM
- 82a: oberer Polschuhteil
- 82b: unterer Polschuhteil

## Patentansprüche

1. Störungsarmer Sensorkopf (30) für einen Röntgendetektor (74), umfassend als Bauteile mindestens
- eine Leiterplatte (10) mit einer Stirnfläche (12),
- einen auf der Stirnfläche (12) der Leiterplatte (10) angeordneten für Röntgenstrahlung (72) empfindlichen Sensorchip (32),
- eine Mehrzahl von Signal- und Steueranschlüssen, enthaltend Kontaktstifte (42) zum Betrieb des Sensorchips (32), wobei die Kontaktstifte (42) zur elektrischen Isolation jeweils von einem röhrenförmigen Glaskörper (44) umschlossen sind, der an beiden Enden offen ist und somit den Kontaktstift (42) zur Kontaktierung freigibt, und
- ein auf einer von der Stirnfläche (12) abgewandten Seite der Leiterplatte (10) angeordnetes Mittel zur Kühlung und/oder Wärmeableitung (36), **dadurch gekennzeichnet,**
**dass** die Mehrzahl der Kontaktstifte (42) aus einem Material oder mehreren Materialien besteht, dessen beziehungsweise deren Permeabilitätszahl (µᵣ) kleiner als 1,5 ist und das beziehungsweise die ausgewählt ist/sind aus geglühten Nickel-Legierungen und geglühtem austenitischen Edelstahl mit der Werkstoffnummer 1.4429, 1.4406, 1.4404, 1.4301, 1.3964, 1.3960 und 1.3952.

2. Störungsarmer Sensorkopf (30) nach Anspruch 1, **dadurch gekennzeichnet, dass** der Sensorkopf (30) ferner eine Bodenplatte (50) zur Einfassung der Kontaktstifte (42) aufweist, wobei die Bodenplatte (50) aus einem Material oder mehreren Materialien besteht, dessen beziehungsweise deren Permeabilitätszahl (µᵣ) kleiner als 1,5 ist.

3. Störungsarmer Sensorkopf (30) nach einem der vorhergehenden Ansprüche, **dadurch gekennzeichnet, dass** der Sensorkopf (30) von einem Gehäuse (56) umschlossen ist, wobei das Gehäuse (56) im Bereich des Sensorchips (32) ein Eingangsfenster (58) aufweist und das Gehäuse (56) aus einem Material oder mehreren Materialien besteht, dessen beziehungsweise deren Permeabilitätszahl (µᵣ) kleiner als 1,5 ist.

4. Störungsarmer Sensorkopf (30) nach einem der Ansprüche 1 bis 3, **dadurch gekennzeichnet, dass** der Sensorkopf (30) in den Seitenbereichen von einem Gehäuse (56) umschlossen ist, wobei das Gehäuse (56) mit dem Sensorchip (32) bündig abschließt und das Gehäuse (56) aus einem Material oder mehreren Materialien besteht, dessen beziehungsweise deren Permeabilitätszahl (µᵣ) kleiner als 1,5 ist.

5. Störungsarmer Sensorkopf (30) nach einem der vorhergehenden Ansprüche, **dadurch gekennzeichnet, dass** Haftschichten und/oder Sperrschichten zwischen den Bauteilen dünner als 3 µm, vorzugsweise dünner als 2 µm, noch bevorzugter dünner als 1,5 µm sind und/oder aus einem Material oder mehreren Materialien bestehen, dessen beziehungsweise deren Permeabilitätszahl (µᵣ) kleiner als 1,5 ist.

6. Störungsarmer Sensorkopf (30) nach einem der vorhergehenden Ansprüche, **dadurch gekennzeichnet, dass** das eine Material oder die mehreren Materialien der Kontaktstifte (42), der Bodenplatte (50), des Gehäuses (56), der Haftschichten und/oder der Sperrschichten eine Permeabilitätszahl (µᵣ) kleiner als 1,35, vorzugsweise kleiner als 1,2, noch bevorzugter kleiner als 1,1 aufweist beziehungsweise aufweisen.

7. Störungsarmer Sensorkopf (30) nach einem der vorhergehenden Ansprüche, **dadurch gekennzeichnet, dass** die Bodenplatte (50) und/oder das Gehäuse (56) aus einem Material bestehen ausgewählt aus der Gruppe umfassend austenitischen Edelstahl, geglühte Nickel-Legierungen, Tantal, Zirkonium, Wolfram, Platin, Palladium, Titan oder Mischungen daraus.

8. Störungsarmer Sensorkopf (30) nach einem der vorhergehenden Ansprüche, **dadurch gekennzeichnet, dass** die Verbindung der Bauteile lotfrei ist oder aus einem Lot besteht, dessen Permeabilitätszahl (µᵣ) kleiner als 1,5, vorzugsweise kleiner als 1,35, bevorzugter kleiner als 1,2 und noch bevorzugter kleiner als 1,1 ist.

9. Störungsarmer Sensorkopf (30) nach einem der vorhergehenden Ansprüche, **dadurch gekennzeichnet, dass** das Lot weniger als 50% Nickel, vorzugsweise weniger als 20% Nickel, noch bevorzugter weniger als 10% Nickel, am meisten bevorzugt 0% Nickel enthält.

10. Störungsarmer Sensorkopf (30) nach Anspruch 8 oder 9, **dadurch gekennzeichnet, dass** das Lot Silber, Gold, Kupfer, Palladium oder eine Mischung daraus, vorzugsweise eine Mischung aus Silber und Kupfer, umfasst.

11. Störungsarmer Sensorkopf (30) nach einem der vorhergehenden Ansprüche, **dadurch gekennzeichnet, dass** das Mittel zur Kühlung und/oder Wärmeableitung (36) ein thermoelektrisches Kühlelement (34) und einen Sockel (52) umfasst.

12. Störungsarmer Sensorkopf (30) nach Anspruch 11, **dadurch gekennzeichnet, dass** der Sockel (52) aus Kupfer, Silber, Gold, oder Mischungen daraus, noch bevorzugter aus Kupfer besteht.

13. Strahlungsdetektor (74), insbesondere EDX-Detektor, mit einem störungsarmen Sensorkopf (30) nach einem der Ansprüche 1 bis 12.

14. Verwendung eines störungsarmen Sensorkopfes (30) nach einem der Ansprüche 1 bis 12 oder eines Strahlungsdetektors (74) nach Anspruch 13 zur Detektion von Röntgenstrahlung in einem Mikroskop mit einer Optik für geladene Teilchen, insbesondere in einem Elektronen- oder Ionenmikroskop.

## Claims

1. Low interference sensor head (30) for an X-ray radiation detector (74), comprising as components at least
- a printed circuit board (10) with a front surface (12),
- a sensor chip (32) arranged on the front surface (12) of the printed circuit board (10) and sensitive to X-ray radiation (72),
- a plurality of signal and control connections containing contact pins (42) for operating the sensor chip (32), wherein the contact pins (42) are each enclosed by a tubular glass body for electrical isolation, which is open at both ends thus leaving the contact pin (42) free to be contacted, and
- a means for cooling and/or heat removal (36) arranged on a side of the printed circuit board (10) facing away from the front surface (12), **characterized in that**
the majority of the contact pins (42) consists of one material or several materials, the relative permeability (µᵣ) of which is less than 1.5, and which is selected from annealed nickel alloys and annealed austenitic stainless steel with material number 1.4429, 1.4406, 1.4404, 1.4301, 1.3964, 1.3960 or 1.3952.

2. The low interference sensor head (30) according to claim 1, **characterized in that** the sensor head (30) furthermore comprises a base plate (50) for holding the contact pins (42), wherein the base plate (50) consists of one material or several materials, the relative permeability (µᵣ) of which is less than 1.5.

3. The low interference sensor head (30) according to any one of the preceding claims, **characterized in that** the sensor head (30) is enclosed by a housing (56), wherein the housing (56) comprises an input window (58) in the area of the sensor chip (32) and the housing (56) consists of one material or several materials, the relative permeability (µᵣ) of which is less than 1.5.

4. The low interference sensor head (30) according to any one of claims 1 to 3, **characterized in that** the sensor head (30) is enclosed in the side areas by a housing (56), wherein the housing (56) ends flush with the sensor chip (32) and the housing (56) consists of one material or several materials, the relative permeability (µᵣ) of which is less than 1.5.

5. The low interference sensor head (30) according to any one of the preceding claims, **characterized in that** adhesive layers and/or barrier layers between the components are thinner than 3 µm, preferably thinner than 2 µm, more preferably thinner than 1.5 µm and/or consist of one material or several materials, the relative permeability (µᵣ) of which is less than 1.5.

6. The low interference sensor head (30) according to any one of the preceding claims, **characterized in that** the one material or the several materials of the contact pins (42), the base plate (50), the housing (56), the adhesive layers and/or the barrier layers have a relative permeability (µᵣ) which is less than 1.35, preferably less than 1.2, and even more preferably less than 1.1.

7. The low interference sensor head (30) according to any one of the preceding claims, **characterized in that** the base plate (50) and/or the housing (56) consist of a material selected from the group comprising austenitic stainless steel, annealed nickel alloys, tantalum, zirconium, tungsten, platinum, palladium, titanium or mixtures thereof.

8. The low interference sensor head (30) according to any one of the preceding claims, **characterized in that** the connection between the components is solder-free, or consists of a solder, the relative permeability (µᵣ) of which is less than 1.5, preferably less than 1.35, more preferably less than 1.2, and even more preferably less than 1.1.

9. The low interference sensor head (30) according to any one of the preceding claims, **characterized in that** the solder contains less than 50% nickel, preferably less than 20% nickel, even more preferably less than 10% nickel, and most preferably 0% nickel.

10. The low interference sensor head (30) according to either of claims 8 or 9, **characterized in that** the solder comprises silver, gold, copper, palladium or a mixture thereof, preferably a mixture of silver and copper.

11. The low interference sensor head (30) according to any one of the preceding claims, **characterized in that** the means for cooling and/or heat removal (36) comprises a thermoelectric cooling element (34) and a base (52).

12. The low interference sensor head (30) according to claim 11, **characterized in that** the base (52) consists of copper, silver, gold or mixtures thereof, even more preferably of copper.

13. Radiation detector (74), in particular an EDX detector, with a low interference sensor head (30) according to any one of claims 1 to 12.

14. Use of a low interference sensor head (30) according to any one of claims 1 to 12 or a radiation detector (74) according to claim 13 for detecting X-ray radiation in a microscope with optics for charged particles, in particular in an electron microscope or ion microscope.

## Revendications

1. Tête de capteur peu sensible aux pannes (30) pour un détecteur de rayons X (74), comprenant comme composants au moins
- un circuit imprimé (10) avec un côté frontal (12),
- une puce de capteur (32) sensible aux rayons X (72) disposée sur le côté frontal (12) du circuit imprimé (10),
- une pluralité de connexions de signal et de commande, comprenant des broches de contact (42) pour le fonctionnement de la puce de capteur (32), les broches de contact (42) étant respectivement entourées par un corps de verre (44) en forme de tube pour l'isolation électrique, lequel est ouvert aux deux extrémités et libère ainsi la broche de contact (42) pour la connexion, et
- un moyen disposé sur un côté du circuit imprimé (10) non orienté vers le côté frontal (12), pour le refroidissement et/ou la dissipation de chaleur (36), **caractérisée en ce que**
la pluralité des broches de contact (42) se composent d'un matériau ou de plusieurs matériaux, dont la perméabilité relative (µᵣ) est inférieure à 1,5, et qui est ou sont sélectionné(s) parmi le groupe se composant d'alliages de nickel recuits et d'acier spécial austénitique recuit avec numéro de matériau 1,4429, 1,4406, 1,4404, 1,4301, 1,3964, 1,3960 et 1,3952.

2. Tête de capteur peu sensible aux pannes (30) selon la revendication 1, **caractérisée en ce que** la tête de capteur (30) présente en outre une plaque de base (50) pour entourer des broches de contact (42), la plaque de base (50) se composant d'un matériau ou de plusieurs matériaux, dont la perméabilité relative (µᵣ) est inférieure à 1,5.

3. Tête de capteur peu sensible aux pannes (30) selon l'une des revendications précédentes, **caractérisée en ce que** la tête de capteur (30) est entourée par un boîtier (56), le boîtier (56) présentant une fenêtre d'entrée (58) dans la zone de la puce de capteur (32) et **en ce que** le boîtier (56) se compose d'un matériau ou de plusieurs matériaux dont la perméabilité relative (µᵣ) est inférieure à 1,5.

4. Tête de capteur peu sensible aux pannes (30) selon l'une des revendications 1 à 3, **caractérisée en ce que** la tête de capteur (30) est entourée par un boîtier (56) dans les zones latérales, le boîtier (56) étant au ras de la puce de capteur (32), et le boîtier (56) se composant d'un matériau ou de plusieurs matériaux dont la perméabilité relative (µᵣ) est inférieure à 1,5.

5. Tête de capteur peu sensible aux pannes (30) selon l'une des revendications précédentes, **caractérisée en ce que** des couches adhésives et/ou des couches de barrage entre les composants sont plus minces que 3 µm, de préférence plus minces que 2 µm, encore plus préférablement plus minces que 1,5 µm et/ou se composent d'un matériau ou de plusieurs matériaux dont la perméabilité relative (µᵣ) est inférieure à 1,5.

6. Tête de capteur peu sensible aux pannes (30) selon l'une des revendications précédentes, **caractérisée en ce que** l'un matériau ou les plusieurs matériaux des broches de contact (42), de la plaque de base (50), du boîtier (56), des couches adhésives et/ou des couches de barrage présente ou présentent un perméabilité relative (µᵣ) inférieure à 1,35, de préférence inférieure à 1,2, encore plus préférablement inférieure à 1,1.

7. Tête de capteur peu sensible aux pannes (30) selon l'une des revendications précédentes, **caractérisée en ce que** la plaque de base (50) et/ou le boîtier (56) se compose(nt) d'un matériau sélectionné parmi le groupe se composant de : acier spécial austénitique, alliages de nickel recuits, tantale, zirconium, wolfram, platine, palladium, titane ou mélanges de ceux-ci.

8. Tête de capteur peu sensible aux pannes (30) selon l'une des revendications précédentes, **caractérisée en ce que** la liaison des composants est sans soudure ou se compose d'une soudure dont la perméabilité relative (µᵣ) est inférieure à 1,5, de préférence inférieure à 1,35, plus préférablement inférieure à 1,2, et encore plus préférablement inférieure à 1,1.

9. Tête de capteur peu sensible aux pannes (30) selon l'une des revendications précédentes, **caractérisée en ce que** la soudure comprend moins de 50 % de nickel, de préférence moins de 20 % de nickel, encore plus préférablement moins de 10 % de nickel, le plus préférablement 0 % de nickel.

10. Tête de capteur peu sensible aux pannes (30) selon la revendication 8 ou 9, **caractérisée en ce que** la soudure comprend de l'argent, de l'or, du cuivre, du palladium ou un mélange de ceux-ci, de préférence un mélange d'argent et de cuivre.

11. Tête de capteur peu sensible aux pannes (30) selon l'une des revendications précédentes, **caractérisée en ce que** le moyen pour le refroidissement ou la dissipation de chaleur (36) comprend un élément de refroidissement thermoélectrique (34) et un socle (52).

12. Tête de capteur peu sensible aux pannes (30) selon la revendication 11, **caractérisée en ce que** le socle (52) se compose de cuivre, d'argent, d'or ou d'un mélange de ceux-ci, encore plus préférablement de cuivre.

13. Détecteur de rayonnement (74), en particulier détecteur EDX, avec une tête de capteur peu sensible aux pannes (30) selon l'une des revendications 1 à 12.

14. Utilisation d'une tête de capteur peu sensible aux pannes (30) selon l'une des revendications 1 à 12 ou d'un détecteur de rayonnement (74) selon la revendication 13 pour la détection de rayons X dans un microscope avec une optique pour particules chargées, en particulier dans un microscope électronique ou ionique.
